# EUROPEAN PATENT APPLICATION

(11) **EP 4 527 816 A2**
(43) Date of publication of application: **26.03.2025**
(21) Application number: 24196641.5
(22) Date of filing: 27.08.2024
(51) Int. Cl.: C04B 41/00, C04B 41/45, C04B 41/87

(54) **SUBSTRATE COATED WITH A SILICON-CARBIDE (SIC) LAYER AND A METHOD OF MANUFACTURING THE SAME**

(30) Priority: 31.08.2023 SE 2351030
(71) Applicant: STMicroelectronics International N.V., 1228 Plan-les-Ouates, Geneva (CH)
(72) Inventor: MAGNUSSON LINDGREN, Bjorn, 60379 Norrköping (SE); ISACSON, Mathias, 60379 Norrköping (SE)
(74) Representative: Studio Torta S.p.A.

(57) **Abstract**

A structure including a base portion (*e*.*g*., made of a graphite-based or graphene-based material) with at least one surface that is coated with a homogenous coating layer (*e.g.,* made of silicon-carbide (SiC)). The homogenous coating layer prevents contaminants (*e*.*g*., carbon) from being released by the base portion into a cavity of a processing tool when heated to process one or more workpieces (*e*.*g*., silicon substrate, silicon wafers, etc.) present within the cavity. The homogenous coating layer includes grains and grain boundaries that are relatively the same size and shape as each other, which further prevents propagation of defects (*e*.*g*., cracking, peeling, etc.) that could potentially cause exposure of a region of the first surface of the base portion to the cavity of the processing tool contaminating the one or more workpieces present within the cavity of the processing tool.

## Description

### TECHNICAL FIELD

The present invention is directed to a substrate such as a graphite or graphene substrate coated with a coating layer such as silicon-carbide (SiC) coating layer and a method of manufacturing the same.

### STATE OF THE ART

Generally, furnaces or heating systems or tools include a heating chamber that is lined with a graphite substrate. When the heating chamber is heated to manufacture or process a silicon-based substrate (*e.g*., a polycrystalline silicon-carbide (SiC) substrate or workpiece), the graphite substrate is heated and releases carbon into the heating chamber polluting the heating chamber with the released carbon. This carbon that is released into the heating chamber when forming or processing the silicon-based substrate may contaminate the silicon-based substrate such that the silicon-based substrate is manufactured outside of selected tolerances. When the silicon-based substrate is manufactured outside of selected tolerances, the silicon-based substrate cannot be sold to customers or consumers, and, instead, becomes waste that is disposed of or thrown out.

A surface of the graphite substrate may be coated with a silicon-carbide (SiC) layer or a tantalum-carbide (TaC) layer to prevent the carbon releasing from the graphite into the heating chamber. However, when the SiC layer or the TaC layer is exposed to the heat when heating the heating chamber, the SiC layer or TaC layer begins to expand and contract resulting in peeling or delamination from the surface of the graphite substrate, or resulting in cracking or other defects being generated within the SiC layer or TaC layer. This peeling, delamination, cracking, or defects result in the surface of the graphite becoming exposed from the SiC layer or TaC layer such that the graphite releases carbon into the heating chamber. Again, this carbon released into the heating chamber contaminates the heating chamber and contaminates a silicon-based substrate being formed or being processed within the heating chamber.

### BRIEF SUMMARY

The present invention relates to a device and a method, as defined in the annexed claims.

The present invention is more particularly directed to providing a silicon-carbide (SiC) coating layer formed on a surface of a substrate, which may be made of a graphite material or graphene material, that prevents or reduces the likelihood of peeling, delamination, cracking, or other types of defects in the silicon-carbide coating layer on the substrate.

The following are non-limiting examples of the present disclosure.

In at least one embodiment of the present disclosure, a device includes a substrate, which may be graphite, graphene, or some other graphite-based or graphene-based substrate, that lines a cavity of a heating chamber of a workpiece processing or manufacturing tool. The substrate includes a first surface and a silicon-carbide (SiC) coating layer that coats and covers the first surface of the substrate. The SiC coating layer includes a plurality of grains having a grain size within a grain size range of 1 µm to 5 µm, or equal to the upper and lower ends of the grain size range. The SiC coating layer is made using a carbon to silicon ratio in a range of 0.5 to 2.5, or equal to the upper and lower ends of the silicon-carbide range. The SiC coating layer has a homogenous distribution of the plurality of grains as the plurality of grains have substantially the same size and shape along the entirety of the SiC coating layer, and the plurality of grains of the SiC coating layer are non-columnar.

The present disclosure is further directed to at least one embodiment of a method of manufacturing the at least one embodiment of a device in which the SiC coating layer is formed on the first surface of the substrate, which again may be graphite, graphene, or some other graphite-based or graphene-based substrate. For example, in this at least one embodiment of the method of manufacturing this at least one embodiment of the device in which the SiC coating layer is on the first surface of the substrate includes forming the SiC coating layer with the homogenous distribution of grain sizes on the surface of the graphite substrate. Forming the SiC coating layer on the surface of the graphite substrate includes exposing the surface of the graphite substrate to a first ratio of silicon and carbide for a first selected period of time, and exposing the surface of the graphite substrate to a second ratio of silicon and carbide for a second selected period of time.

### BRIEF DESCRIPTION OF THE DRAWINGS

For a better understanding of the embodiments, reference will now be made by way of example to the accompanying drawings. In the drawings, identical reference numbers identify the same or similar elements or acts unless the context indicates otherwise. The sizes and relative proportions of the elements in the drawings are not necessarily drawn to scale. For example, some of these elements may be enlarged and positioned to improve drawing legibility.
Figure 1A is a side view of a structure including a base portion coated with a non-homogenous coating layer;
Figure 1B is a zoomed in, enhanced view of section A-A of the structure as shown in Figure 1A with the base portion coated with the non-homogenous coating layer;
Figure 2A is a side view of an embodiment of a structure of the present disclosure including a base portion coated with a homogenous coating layer;
Figure 2B is a zoomed in, enhanced view of section B-B of the structure as shown in Figure 2A with the base portion coated with the homogenous coating layer;
Figure 3A is a first perspective view of an embodiment of a heating chamber of the present disclosure;
Figure 3B is a second perspective view of an embodiment of the heating chamber as shown in Figure 3A of the present disclosure;
Figure 4 is a perspective view of an alternative embodiment of a heating chamber of the present disclosure;
Figure 5 is a flowchart of an embodiment of a method of forming the structure as shown in Figures 2A and 2B of the present disclosure; and
Figures 6A-6C are side views of respective steps of the embodiment of the method of forming the structure as shown in Figures 2A and 2B of the present disclosure.

### DETAILED DESCRIPTION

In the following description, certain details are set forth in order to provide a thorough understanding of various embodiments of devices, methods, and articles. However, one of skill in the art will understand that other embodiments may be practiced without these details. In other instances, well-known structures and methods associated with, for example, silicon carbide substrates or layers (*e.g*., polycrystalline silicon carbide, monocrystalline silicon carbide, etc.), semiconductor fabrication processes, etc., have not been shown or described in detail in some figures to avoid unnecessarily obscuring descriptions of the embodiments.

Unless the context requires otherwise, throughout the specification and claims which follow, the word "comprise" and variations thereof, such as "comprising," and "comprises," are to be construed in an open, inclusive sense, that is, as "including, but not limited to."

Reference throughout this specification to "one embodiment," or "an embodiment" means that a particular feature, structure or characteristic described in connection with the embodiment is included in at least one embodiment. Thus, the appearances of the phrases "in one embodiment," or "in an embodiment" in various places throughout this specification are not necessarily referring to the same embodiment, or to all embodiments. Furthermore, the particular features, structures, or characteristics may be combined in any suitable manner in one or more embodiments to obtain further embodiments.

The headings are provided for convenience only, and do not interpret the scope or meaning of this disclosure or the claims.

The sizes and relative positions of elements in the drawings are not necessarily drawn to scale. For example, the shapes of various elements and angles may not be drawn to scale, and some of these elements may be enlarged and positioned to improve drawing legibility.

The use of "transverse" means that a surface, a sidewall, or similar or like structure or feature being at an angle with respect to another respective surface, sidewall, or similar or like respective structure or feature. For example, if a first surface is transverse to a first sidewall, the first surface is at an angle that is equal to 25-degrees, 35-degrees, 45-degrees, 75-degrees, 90-degrees, 120-degrees, and so forth.

Generally, graphite or graphene substrates, portions, or components are utilized to line a heating chamber of a workpiece manufacturing or processing tool that is configured to, in operation, form, process, or refine workpieces (*e.g*., wafers) within a semiconductor manufacturing plant (FAB) to manufacture semiconductor or electronic devices (*e.g*., semiconductor packages, semiconductor die, or other similar or like types of semiconductor or electronic devices). These graphite substrates are relatively resistant against damage due to thermal expansion and contraction when exposed to increases and decreases in temperature when a cavity in the heating chamber is heated up by a heating element or cooled down to form workpieces in cavity of the heating chamber, or to process or refine workpieces within the cavity of the heating chamber. However, when the graphite substrate lining and delimiting the cavity of the heating chamber is exposed to increases in temperature, the graphite substrate releases carbon particles or atoms into the cavity of the heating chamber, which become contaminants or unwanted dopants that are introduced to the workpieces within the heating chamber when manufacturing, processing, or refining the workpieces with the heating chamber. These carbon contaminants, which are unwanted dopants, result in semiconductor devices or components that are manufactured outside of selected tolerances resulting in those out of tolerance semiconductor devices or components being discarded or thrown out. These discarded or thrown out semiconductor devices or components increase waste costs, which increases operation costs of the FAB.

To prevent or reduce the likelihood of the releasing of these carbon contaminants or unwanted dopants from the graphite when exposed to increases in temperature within the cavity of the heating chamber, a surface of the graphite substrate that would be exposed to the cavity of the heating chamber is coated by a non-homogenous, columnar silicon-carbide (SiC) coating layer or tantalum-carbide (TaC) coating layer. While the non-homogenous, columnar SiC or TaC coating layer prevents or reduces the likelihood of carbon contaminants from being released from the graphite substrate into the cavity of the heating chamber, a columnar structure of respective grains of the non-homogenous, columnar SiC or TaC coating layer results in the non-homogenous, columnar SiC or TaC coating layer to either quickly start to delaminate or peel away from the surface of the graphite substrate or quickly begin to crack. This delamination, peeling, or cracking results in respective regions of the surface of the graphite substrate quickly becoming exposed from the non-homogenous, columnar SiC or TaC coating layer such that carbon contaminants are again released from the surface of the graphite substrate into the cavity of the heating chamber. The non-homogenous, columnar SiC or TaC coating layer further has grains of different sizes and shape. Again these carbon contaminants, which are unwanted dopants, result in semiconductor devices or components that are manufactured outside of selected tolerances resulting in those out of tolerance semiconductor devices or components being discarded or thrown out. These discarded or thrown out semiconductor devices or components increase waste costs, which increases operation costs of the FAB.

The present disclosure is directed to one or more embodiments of a graphite substate including a surface that is coated by a homogenous, non-columnar SiC or TaC coating layer, which has a plurality of grains having a homogenous or uniform distribution of grain sizes (*e.g*., grains all being relatively the same size and shape) and the respective grains having a non-columnar shape. The homogenous, non-columnar SiC or TaC coating layer prevents or mitigates the issues as discussed directly above with respect to the non-homogenous, columnar SiC or TaC coating layer. Respective grains of the plurality of grains of the homogenous, columnar SiC or TaC coating layer are all within a range of grain sizes and are all substantially the same shape. Furthermore, ideally all the respective grains of the plurality of grains would be exactly the same size and be exactly the same shape. The shape of the grains are of a non-columnar shape. The homogenous or uniform distribution of grain sizes of the plurality of grains along with their non-columnar shape further prevents or reduces the likelihood of delamination or peeling of the homogenous, non-columnar SiC or TaC coating layer from the surface of the graphite substrate, and further prevents or reduces the likelihood of the homogenous, non-columnar SiC or TaC coating layer cracking. For example, the homogenous and uniform distribution of grain sizes of the plurality of grains increases the robustness and resistance of the homogenous, non-columnar SiC coating layer at higher temperatures (*e.g*., at least up to 1700 degrees Celsius) relative to the non-homogenous, columnar SiC or TaC coating layer as discussed above. The homogenous or uniform distribution of grain sizes of the plurality of grains along with the respective grains having the non-columnar shape allows for the respective grains of the homogenous, non-columnar SiC coating layer to more readily expand and contract without generating undue stresses and strains that result in delamination, peeling, or cracking, or result in an increase in the likelihood of delamination, peeling, or cracking. Accordingly, the present disclosure is directed to one or more embodiments of the graphite substrate including the homogenous, non-columnar SiC or TaC coating layer, which has the plurality of grains having the homogenous or uniform distribution of grains sizes with the respective grains having the non-columnar shape.

Furthermore, the present disclosure is directed to one or more embodiments of a method of manufacturing the one or more embodiments of the graphite substate including the surface that is coated by the homogenous, non-columnar SiC coating layer, which has the plurality of grains having the homogenous or uniform distribution of grain sizes and the respective grains having the non-columnar shape. The details of the one or more embodiments of the method of manufacturing these one or more embodiments of the graphite substrate coated with the homogenous, non-columnar SiC coating layer will be discussed in detail later herein.

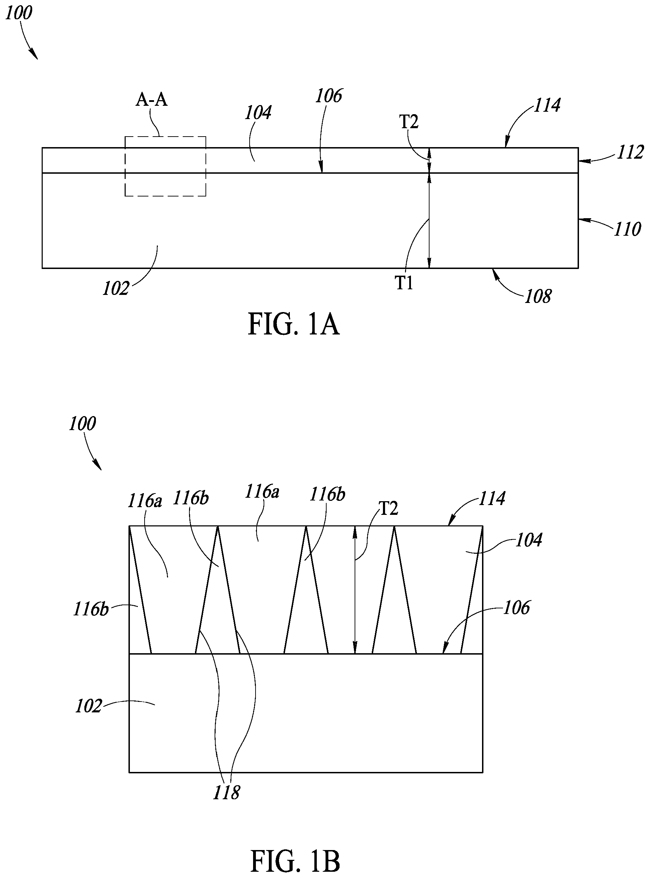

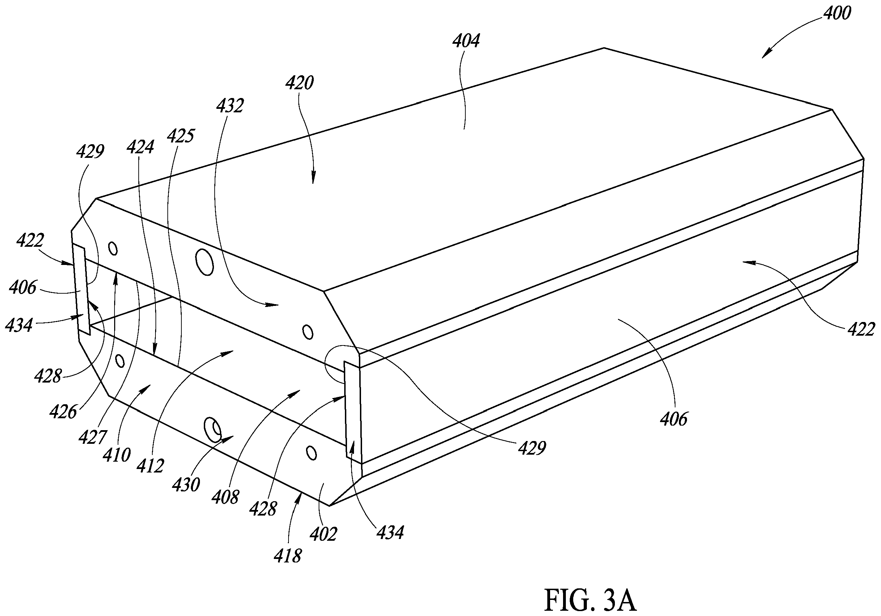

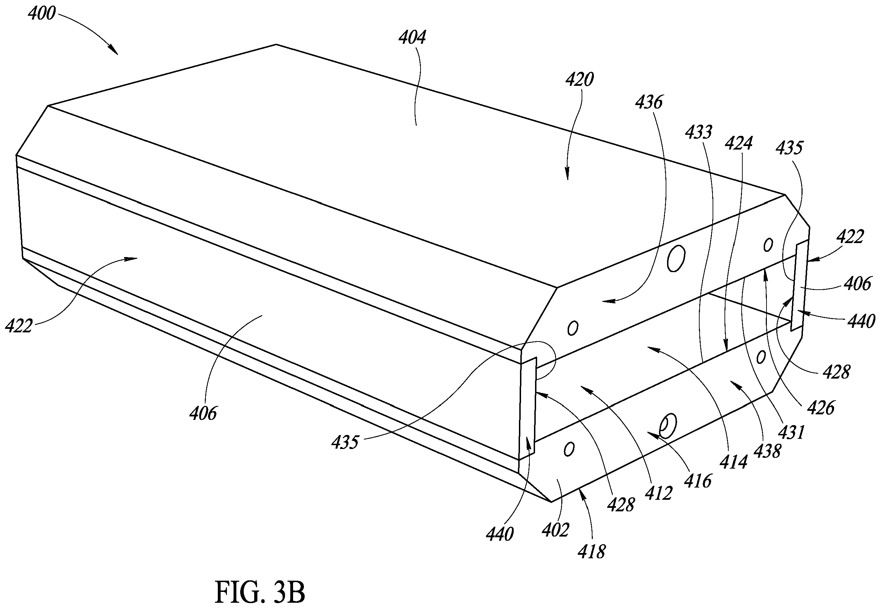

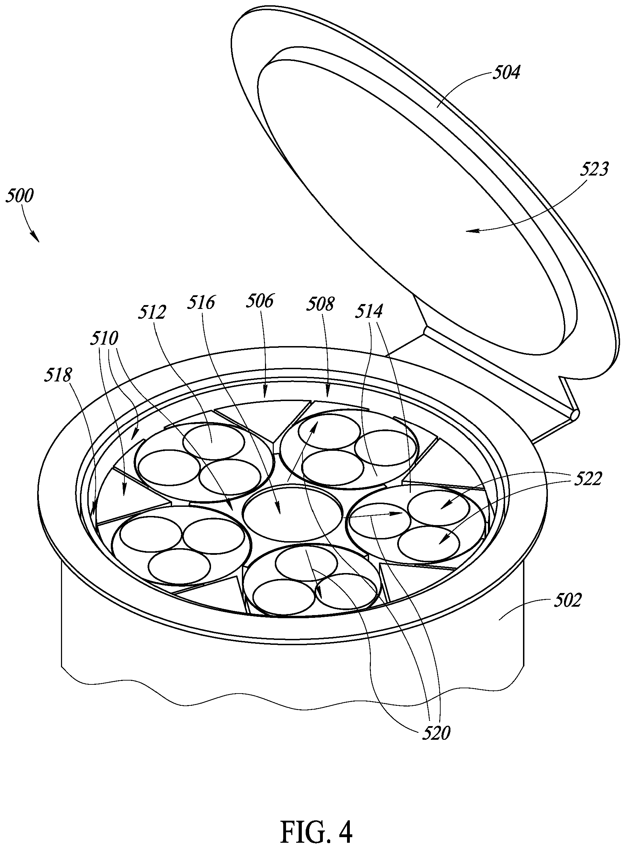

Figure 1A is a side view of a structure 100 including a base portion 102 coated with a non-homogenous coating layer 104. The base portion 102 includes a first surface 106 and a second surface 108 opposite to the first surface 106. The base portion 102 is made of a graphite material, a graphite-based material, a graphene material, a graphene-based material, or some other similar or like type of graphite or graphene material. The base portion 102 is in particular a substrate or a component that is utilized in lining or forming a cavity of a heating chamber or structure for heating one or more workpieces (see Figures 3A, 3B, and 4 of the present disclosure).

The non-homogenous coating layer 104 is a silicon-carbide (SiC) coating layer. In some alternatives, the non-homogenous coating layer 104 is a tantalum-carbide (TaC) coating layer. The non-homogenous coating layer 104 is along, at, on and fully covers the first surface 106 of the base portion 102.

One or more first sidewalls 110 of the base portion 102 are coplanar with one or more second sidewalls 112 of the non-homogenous coating layer 104. The base portion 102 further includes a first thickness T1 that extends from the first surface 106 to the second surface 108, and the non-homogenous coating layer 104 has a second thickness T2 that extends from the first surface 106 to a third surface 114 of the non-homogenous coating layer 104. The third surface 114 of the non-homogenous coating layer 104 faces away from the base portion 102. The first thickness T1 is greater than the second thickness T2. The first thickness T1 is within the range of 1 µm (micrometers) to 10 µm (micrometers), or is equal to the upper and lower ends of this range. The second thickness T2 is within the range of 1 µm to 10 µm , or is equal to the upper and lower ends of this range.

Figure 1B is a zoomed in, enhanced view of section A-A of the structure 100 as shown in Figure 1A. As shown in Figure 1B, the non-homogenous coating layer 104 has a columnar structure such that grains 116a, 116b of the non-homogenous coating layer 104 are columnar grains. The grains 116a, 116b include first columnar grains 116a and second columnar grains 116b. The first columnar grains 116a are larger than the second columnar grains 116b. As shown in Figure 1B, the first columnar grains 116a have a trapezoidal profile or shape and the second columnar grains 116b have a triangular profile or shape. The non-homogenous coating layer 104 is non-homogenous or non-uniform as the first columnar grains 116a are larger than the second columnar grains 116b such that the non-homogenous coating layer 104 is susceptible to defects (*e.g*., peeling, delaminating, cracking, etc.) propagating when the non-homogenous coating layer 104 is exposed to successive repeated increases and decreases in temperature when processing or manufacturing workpieces.

As shown in Figure 1B, a plurality of columnar grain boundaries 118 are present between the first and second columnar grains. Each respective columnar grain boundary 118 of the plurality of columnar grain boundaries 118 is between a pair of the first and second columnar grains 116a, 116b. At least as shown in Figure 1B, the plurality of columnar grain boundaries 118 extend from the first surface 106 of the base portion 102 to the third surface 114 of the non-homogenous coating layer 104. In some alternative situations, the second columnar grains 116b is slightly smaller in profile than as shown in Figure 1B such that there are grain boundaries between adjacent ones of the first columnar grains 116a.

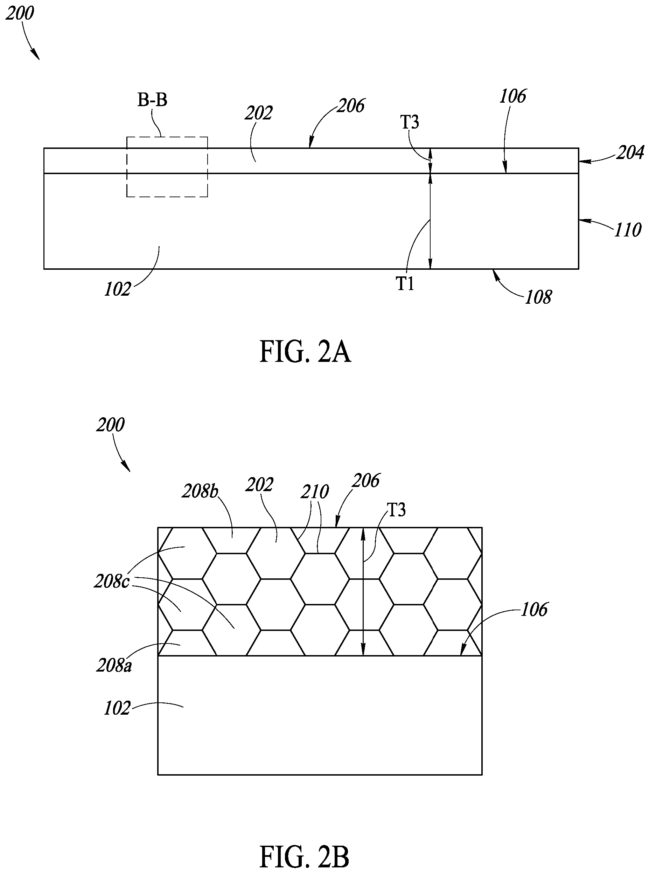

Figure 2A is a side view of an embodiment of a structure 200 of the present disclosure including the base portion 102 coated with a homogenous coating layer 202. The structure 200 includes at least some of the same or similar features of the structure 100 as shown in Figure 1A. These same or similar features have been provided with the same or similar reference numerals. For the sake of simplicity and brevity of the present disclosure, the details of these same or similar features may not fully reproduced herein.

The homogenous coating layer 202 is a silicon-carbide (SiC) coating layer. In some alternative embodiments, the homogenous coating layer 202 is a tantalum-carbide (TaC) coating layer. The homogenous coating layer 202 is along, at, on, and fully covers the first surface 106 of the base portion 102. The homogenous coating layer 202 is directly coupled to first surface 106 of the base portion 102 such that the homogenous coating layer 202 is in direct physical contact and abutment with the first surface 106 of the base portion 102. In other words, in the embodiment as shown in Figure 2A, no material is present between the homogenous coating layer 202 and the base portion 102 such that the homogenous coating layer 202 is directly coupled to the first surface 106 of the base portion 102.

One or more second sidewalls 204 of the homogenous coating layer 202 are coplanar with the one or more first sidewalls 110 of the base portion 102. The homogenous coating layer 202 includes a third thickness T3 that extends from the first surface 106 of the base portion 102 to the third surface 206 of the homogenous coating layer 202. The third surface 206 of the homogenous coating layer 202 faces away from the base portion 102. The third thickness T3 is within the range of 1 µm to 10 µm, or is equal to the upper and lower ends of this range.

In at least one embodiment, the homogenous coating layer 202 is a polycrystalline layer and the base portion 102 is a polycrystalline layer. In at least one embodiment, the homogenous coating layer 202 is a majority of 3C (cubic) polycrystalline. For example, the homogenous coating layer 202 is made of at least 90 % of 3C polycrystalline. In at least one embodiment, the base portion 102 is a majority of polycrystalline.

In at least one embodiment, the homogenous coating layer is a non-amorphous layer. In at least one embodiment, the base portion 102 is a non-amorphous layer.

The homogenous coating layer 202 has a thermal conductivity within a range from 150 to 300 W/(m*K) (Watts/(meters*kelvin)), or is equal to the upper and lower ends of this range. In at least one embodiment, the thermal conductivity is preferably within a range from 230-290 W/(m*K), or equal to the upper and lower ends of this range.

The homogenous coating layer 202 has a transparency ranging from 90% to 99%, or is equal to the upper and lower ends of this range. In at least one embodiment, the homogenous coating layer 202 is transparent without green color such that the absorption of light within a visible wavelength region is at least less than or equal to 20% or preferable less than or equal to 10%. For example, the typical absorption is ranging from 1%-5%.

Figure 2B is a zoomed in, enhanced view of section B-B of the structure 200 as shown in Figure 2A. As shown in Figure 2B, the homogenous coating layer 202 has a non-columnar structure such that grains 208a, 208b of the homogenous coating layer 202 are non-columnar grains. In other words, the grains 208 include first non-columnar grains 208a at the first surface 106 of the base portion 102, second non-columnar grains 208b at the third surface 206, and third non-columnar grains 208c some of which are between the first surface 106 and the third surface 206 or are at the first surface 106 and the third surface 206, respectively. The homogenous coating layer 202 is homogenous and uniform as a majority of or most of the grains 208a, 208b, 208c are all relatively and substantially equal in size to each other. Furthermore, the non-columnar grains 208a, 208b, 208c are all relatively and substantially the same shape to each other. For example, while the first non-columnar grains 208a and the second non-columnar grains 208b are smaller than the third non-columnar grains 208c, the majority of the grains 208a, 208b, 208c are the third non-columnar grains 208c such that the homogenous coating layer 202 is homogenous or uniform. The homogenous coating layer 202 includes a plurality of non-columnar grain boundaries 210 that are between adjacent ones of the first, second, and third non-columnar grains 208a, 208b, 208c. The plurality of non-columnar grain boundaries 210 of the homogenous coating layer 202 are much smaller than the plurality of columnar grain boundaries 118 of the non-homogenous coating layer 104.

The grains 208a, 208b have a grain size ranging from 1 micrometer (µm) to 5 micrometers (µm), or have a grain size equal to the upper and lower ends of this range. The grains 208c have a grain size ranging from 1 micrometer (µm) to 5 micrometer (µm), or have a grain size equal to the upper and lower ends of this range. Even when the grain sizes are equal to lower ends of these ranges, in at least one embodiment, the homogenous layer 202 have a high thermal conductivity, for example, being equal to 250 W/(m*K). When the homogenous coating layer 202 has respective grains that are small and has a high CTE relative to other similar amorphous, non-amorphous, or polycrystalline materials, the homogenous coating layer 202 is extremely robust against the propagation of defects when exposed to changes (*i.e*., increases or decreases) in temperature. This is possible as the homogenous coating layer 202 is formed on the first surface 106 of the base portion 102 by a chemical vapor deposition (CVD) process. In the CVD process utilized to form the homogenous coating layer 202 on the first surface 106 of the base portion 102, the CVD process includes providing gases from sources of gases so a growth process is made without particle nucleation in a gas phase allowing the grain boundaries between the grains 208a, 208b, 208c to not limit the thermal conductivity of the homogenous coating layer 202.

The homogenous coating layer 202 is less susceptible (*i.e.*, more robust) to defects propagating or occurring within the homogenous coating layer 202 when the homogenous coating layer is exposed to successive increases or decreases in temperature as compared to the non-homogenous coating layer 104. For example, the homogenous coating layer may be resistance to temperatures being increased up to at least 1700 degrees Celsius (°C) as compared to the non-homogenous coating layer 104. The homogenous coating layer 202 is more robust than the non-homogenous coating layer 104. The non-homogenous coating layer 104 is only resistant to temperature range of 900 to 1400 °C without cracking or peeling. In other words, the homogenous coating layer 202 is capable of being exposed to increases and decreases in temperatures up to and down from 1700 degrees Celsius (°C) without defects (*e.g*., cracking, peeling, or some other similar or like type of defect) propagating within the homogenous coating layer 202. Accordingly, while there is no likelihood or a low likelihood of defects propagating in the homogenous coating layer 202 when exposed to increases and decreases in temperatures up to and down from 1700 degrees Celsius (°C), there is a high likelihood or guarantee of defects quickly propagating within the non-homogenous coating layer 104 when exposed to increases or decreases in temperatures up to and down from 1700 degrees Celsius (°C). As will become apparent in view of the discussion within this present disclosure, the homogenous coating layer 202 is more robust to greater increases and decreases in temperature as compared to the non-homogenous coating layer 104.

Figures 3A and 3B are perspective views of a heating chamber 400 that is to be utilized in a processing tool. For example, the processing tool is a furnace to process one or more workpieces within the heating chamber 400 or to form layers on one or more workpieces within the heating chamber 400 (*i.e*., a silicon substrate or wafer, a silicon-carbide substrate or wafer, or some other similar or like type of substrate or wafer). The heating chamber 400 includes a first plate or portion 402, a second plate or portion 404 that is spaced apart from the first portion 402, and sidewall plates or portions 406 that extend from the first portion 402 to the second portion 404. The sidewall portions 406 are transverse to the first portion 402 and the second portion 404. In the embodiment of the heating chamber 400 as shown in Figures 3A and 3B, there are two sidewall portions 406 that are opposite to each other. The first portion 402, the second portion 404, and the sidewall portions 406 are made of a graphite material, a graphite-based material, a graphene material, a graphene-based material, or some other similar or like type of graphite or graphene material.

A first opening 408 is at a first end 410 of the heating chamber 400 and provides access to a cavity 412 within the heating chamber 400. The cavity 412 is delimited by the first portion 402, the second portion 404, and the sidewall portions 406. A second opening 414 is at a second end 416 of the heating chamber 400 opposite to the first end 410, and the second opening 414 provides access to the cavity 412 within the heating chamber 400. Either one of the first or second openings 408 allows one or more workpieces to be placed within the cavity 412 of the heating chamber 400. For example, a transfer robot arm (TRA) with an end effector or transfer blade is utilized to insert the one or more workpieces into the cavity 412 through either one of the first or second openings 408, 414 of the heating chamber 400.

The first portion 402 includes a first external surface 418, the second portion 404 includes a second external surface 420, and the sidewall portion 406 includes external sidewall surfaces 422. The first external surface 418, the second external surface 420, and the external sidewall surfaces 422 do not line or delimit the cavity 412 of the heating chamber 400, and the first external surface 418, the second external surface 420, and the external sidewall surfaces 422 do not line or delimit the first and second openings 408, 414 of the heating chamber 400.

The first portion 402 includes a first internal surface 424, the second portion 404 includes a second internal surface 426, and the sidewall portions 406 include internal sidewall surfaces 428. The first internal surface 424, the second internal surface 426, and the internal sidewall surfaces 428 line or delimit the cavity 412 of the heating chamber 400, and the first internal surface 424, the second internal surface 426, and the internal sidewall surfaces 428 line or delimit the first and second openings 408, 414 of the heating chamber 400.

The first portion 402 includes a first end surface 430, the second portion 404 includes a second end surface 432, and the sidewall portion 406 includes first sidewall end surfaces 434. The first end surface 430, the second end surface 432, and the first sidewall end surfaces 434 are at the first end 410 of the heating chamber 400.

The first portion 402 includes a third end surface 436 that is opposite to the first end surface 430, the second portion 404 include a fourth end surface 438 that is opposite to the second end surface 432, and the sidewall portions 406 include second sidewall end surfaces 440 that are opposite to the first sidewall end surfaces 434. The third end surface 436, the fourth end surface 438, and the second sidewall end surfaces 440 are at the second end 416 of the heating chamber 400.

The first internal surface 424, the second internal surface 426, the internal sidewall surfaces 428, the first end surface 430, the second end surface 432, the first sidewall end surfaces 434, the third end surface 436, the fourth end surface 438, and the second sidewall end surfaces 440 are all coated with the homogenous coating layer 202 (see Figure 2A and 2B of the present disclosure), which is homogenous and has the non-columnar structure such that the majority of the grains 208a, 208b, 208c of the homogenous coating layer 202 are all relatively and substantially the same size and shape as each other and are non-columnar grains. A respective portion of the homogenous coating layer 202 on the first end surface 430 is continuous with a respective portion of the homogenous coating layer 202 on the first internal surface 424 such that a first edge 425 is fully coated by the homogenous coating layer 202. A respective portion of the homogenous coating layer 202 on the second end surface 432 is continuous with the respective portion of the homogenous coating layer 202 on the second internal surface 426 such that a second edge 427 is fully coated by the homogenous coating layer 202. Respective portions of the homogenous coating layer 202 on the first sidewall end surfaces 434, respectively, are continuous with respective portions of the homogenous coating layer 202 on the internal sidewall surfaces 428, respectively, such that third edges 429 are fully coated by the homogenous coating layer 202. A respective portion of the homogenous coating layer 202 on the third end surface 436 is continuous with the respective portion of the homogenous coating layer 202 on the second internal surface 426 such that a fourth edge 431 is fully coated by the homogenous coating layer 202. A respective portion of the homogenous coating layer on the fourth end surface 438 is continuous with the respective portion of the homogenous coating layer 202 on the first internal surface 424 such that a fifth edge 433 is fully coated by the homogenous coating layer 202. Respective portions of the homogenous coating layer 202 on the second sidewall end surfaces 440, respectively, are continuous with the respective portions of the homogenous coating layer 202 on the internal sidewall surfaces 428, respectively, such that sixth edges 435 are fully coated by the homogenous coating layer 202. By coating these respective edges 425, 427, 429, 431, 433, 435, the likelihood of peeling occurring at or in close proximity to these respective edges 425, 427, 429, 431, 433, 435 is reduced, which further prevents or reduces the likelihood of contaminants (*e.g*., carbon) from being introduced into the cavity 412 when processing workpieces present within the cavity 412 of the heating chamber 400.

When the heating chamber 400 is being utilized within a processing or furnace tool that contains or includes the heating chamber 400, one or more workpieces are inserted into the cavity 412 of the heating chamber 400. Once the one or more workpieces are inserted into the cavity 412 of the heating chamber 400, a gas (*i.e*., SiH₄, Si₂H₆, GeH₄, or some other similar or like type of gas) from a gas source is introduced and passed through the cavity 412 of the heating chamber 400 while the heating chamber 400 is being heated by a heating element of the process or furnace tool. In at least one embodiment, the gas enters the first opening 408 (*i.e.*, gas inlet), passes through the cavity 412, and exits from the second opening 414 (*i.e.*, gas outlet). In at least one alternative embodiment, the gas flows in a reverse direction such that the gas enters the second opening 414 (*i.e*., gas inlet), passes through the cavity 412, and exits from the first opening 408 (*i.e.*, gas outlet). As the gas moves through the cavity 412, epitaxial layers are formed on respective surfaces of the one or more workpieces present within the cavity 412. The above process is an epitaxial growth formation process in which the epitaxial layers are grown and formed on the respective surfaces of the one or more workpieces present within the cavity 412. Once the epitaxial layers have been grown and formed on the respective surfaces of the one or more workpieces, the gas is stopped from being introduced into the cavity 412 and the heating chamber 400 is allowed to cool down, for example, by stopping the heating element from heating the heating chamber 400. Once the one or more workpieces have cooled down, the end effector of the TRA is utilized to remove the one or more workpieces on which the epitaxial layers were grown and formed utilizing the heating chamber 400.

When the cavity 412 of the heating chamber 400 is heated up, the homogenous coating layers 202 on the respective internal sidewall surfaces 428 and the respective internal surfaces 424, 426 of the respective portions 402, 404, 406 that define the heating chamber 400 is directly exposed to the heat where the respective base portions of these respective portions are not exposed directly to the heat due to the presence of the homogenous coating layers 202. In other words, respective surfaces 206 of the homogenous coating layer 202 are exposed directly to the heat that heats up the cavity 412 of the heating chamber 400. In other words, the homogenous coating layers 202 are lining the entirety of the cavity 412 of the heating chamber 400.

The above process as discussed with respect to Figures 3A, 3B, and 4 to form the epitaxial layers on the one or more workpieces is performed in succession multiple times such that the heating chamber 400 is utilized multiple times to process many workpieces that are inserted into the cavity 412 in succession. If the first internal surface 424, the second internal surface 426, the internal sidewall surfaces 428, the first end surface 430, the second end surface 432, the first sidewall end surfaces 434, the third end surface 436, the fourth end surface 438, and the second sidewall end surfaces 440 were coated with the non-homogenous coating layer 104 instead of the homogenous coating layer 202, defects would quickly begin to propagate within the non-homogenous coating layer 104 as compared to when instead of the homogenous coating layer 202 is on the first internal surface 424, the second internal surface 426, the internal sidewall surfaces 428, the first end surface 430, the second end surface 432, the first sidewall end surfaces 434, the third end surface 436, the fourth end surface 438, and the second sidewall end surfaces 440.

When the non-homogenous coating layer 104 is present on the first surface 106 of the base portion 102, defects begin to propagate relatively quickly and with a relatively high likelihood within the non-homogenous coating layer 104 as compared to when the homogenous coating layer 202 is instead on the first surface 106 of the base portion 102. This is at least due in part to the columnar structure of the first and second columnar grains 116a, 116b having the relatively large columnar grain boundaries 118 as compared to the relatively small non-columnar boundary grains 210. For example, the relatively large columnar grain boundaries 118 are more susceptible to propagation of defects (*e.g*., crack, peeling, etc.) as compared to the susceptibility of the propagation of these defects in the small non-columnar grain boundaries 210 as the small non-columnar grain boundaries 210 more easily and readily reduce or resist stresses and strains generated by increases and decreases in temperature (*i.e.*, expansion and contraction) relative to the large columnar grain boundaries 118.

For example, when there are changes in temperature (*i.e.*, increases and decreases) within the cavity 412 of the heating chamber 400 and the non-homogenous coating layer 104 is on the first surface 106 of the base portion 102, the plurality of grains 116a, 116b expand (*i.e.*, increase in temperature) and contract (*i.e.*, decrease in temperature) due to thermal cycling. This expansion and contraction of the plurality of columnar grains 116a, 116b causes stresses and strains to fluctuate and propagate between the plurality of columnar grains 116a, 116b at the plurality of columnar grain boundaries 118. As the stresses and strains fluctuate, the large columnar grain boundaries 118 begin to separate from each other or push against each other, which results in cracking in the non-homogenous coating layer 104. When a crack occurs or propagates along at least one of the large columnar grain boundaries 118, the crack has a high likelihood of extending from the third surface 114 of the non-homogenous coating layer 104 all the way to the first surface 106 of the base portion 102 resulting in a region of the first surface 106 being exposed to the cavity 412 by fluidic communication through the propagated crack. When the region of the first surface 106 of the base portion 102 is exposed to the cavity 412 of the heating chamber 400, the first surface 106 of the base portion generates carbon that enters into the cavity 412 as a contaminant or unintended dopant that becomes part of epitaxial layers grown or formed on respective surfaces of workpieces (*e.g*., silicon substrate, silicon wafer, etc.) present within the cavity 412. This contaminant causes out-of-tolerance semiconductor devices to be manufactured that become waste costs absorbed by a FAB.

Alternatively, for example, when there are changes in temperature (*i.e.*, increases and decreases) within the cavity 412 of the heating chamber 400 and the homogenous coating layer 202 is on the first surface of the base portion 102, the plurality of grains 116a, 116b expand (*i.e.*, increase in temperature) and contract (*i.e*., decrease in temperature). This expansion and contraction of the plurality of non-columnar grains 208a, 208b, 208c causes stresses and strains to fluctuate and propagate between the plurality of non-columnar grains 208a, 208b, 208c at the plurality of non-columnar grain boundaries 210. As the stresses and strains fluctuate, at least some of the plurality of small non-columnar grain boundaries 210 begin to separate from each other, which may result in cracking. As the plurality of non-columnar grain boundaries 210 are smaller than the plurality of columnar grain boundaries 118, the smaller non-columnar grain boundaries 210 more readily resist or reduce stresses and strains caused by this expansion and contraction due to the thermal cycling. The smaller non-columnar grain boundaries 210 also more evenly distribute the stresses and strains through the smaller non-columnar grain boundaries 210 as compared to the larger columnar grain boundaries 118 such that the smaller non-columnar grain boundaries 210 are more resistant to cracking defects. However, even when a crack does begin to occur or propagate along at least one of the smaller non-columnar grain boundaries 210, the crack has a low likelihood of extending from the third surface 206 of the homogenous coating layer 210 to the first surface 106 of the base portion 102, preventing or reducing a likelihood of a region of the first surface 106 being exposed to the cavity 412 by fluid communication through a crack in the homogenous coating layer 202. In other words, even if a crack begins to propagate along at least one of the small non-columnar grain boundaries 210, the stresses and strains are more evenly distributed since there is a greater number of the smaller non-columnar grain boundaries 210 in the homogenous coating layer 202 as compared to the larger columnar grain boundaries 118 in the non-homogenous coating layer 104. In other words, the smaller non-columnar grains 210 of the plurality of non-columnar grains 208a, 208b, 208c are much more robust against stresses and strains caused by changes in temperature (*i.e.*, increases or decreases) as compared to the larger columnar grains 118 of the plurality of columnar grains 116a, 116b, and, therefore, there is a much lower likelihood of cracks exposing the first surface 106 of the base portion to the cavity 412 of the heating chamber 400 when the homogenous coating layer 202 is on the first surface 106 of the base portion 102 instead of the non-homogenous coating layer 104.

Furthermore, there is a CTE (coefficient of thermal expansion) mismatch between the base portion 102 and the homogenous coating layer 202 and the non-homogenous coating layer 104, respectively. In other words, when exposed to thermal cycling, the base portion 102 expands by a different amount than the homogenous coating layer 202 and the non-homogenous coating layer 104, respectively. As discussed above, as the smaller non-columnar grain boundaries 210 of the homogenous coating layer 202 are more resilient and robust than the larger columnar grain boundaries 118 of the non-homogenous coating layer 104, stresses and strains generated by this CTE mismatch have a lower likelihood of generating defects in the homogenous coating layer 202 as compared to generating defects in the non-homogenous coating layer 104.

In view of the above discussion, as the homogenous coating layer 202 absorbs or mitigates stresses and strains caused by changes in temperature (*i.e*., increase or decreases) as compared to the non-homogenous coating layer 104, the homogenous coating layer 202 is less susceptible to or is more robust against peeling or delamination at or in close proximity to the one or more first sidewalls 110 of the base portion 102 as compared to the non-homogenous coating layer 104.

When the non-homogenous coating layer 104 is present on the first surface 106 of the base portion 102, there is a high likelihood of peeling or delamination occurring at or in close proximity to the one or more first sidewalls 110 of the base portion 102 due to the larger columnar grain boundaries 118, which are more susceptible and less robust due to changes in temperature (*i.e.*, increases or decreases). Alternatively, when the homogenous coating layer 202 is present on the first surface 106 of the base portion 102, there is a lower likelihood of peeling or delamination occurring at or in close proximity to the one or more first sidewalls of the base portion 102 due to the smaller non-columnar grain boundaries 210, which are less susceptible and more robust against changes in temperature (*i.e.*, increases and decrease) as the non-columnar grains 210 are all relatively the same size and shape to each other.

Peeling of the first non-columnar grains 116a of the non-homogenous coating layer 104 at the first surface 106 of the base portion 102 is relatively high in likelihood as compared to peeling of the first and third non-columnar grains 208a, 208c of the non-homogenous coating layer 202 at the first surface 106 of the base portion 102. For example, the trapezoidal shape and larger size of the first columnar grains 116a, which have ends at the first surface 106 that are smaller than ends at the third surface 114 of the non-homogenous coating layer 104, increases the likelihood of peeling of the non-homogenous coating layer 104 from the first surface 106 when exposed to thermal cycling. Alternatively, the first and third non-columnar grains 208a, 208c being relatively the same size and shape to each other and being smaller allows for a greater number of the first and third non-columnar grains 208a, 208b to be present at the first surface 106 relative to the first and second columnar grains 116a, 116b providing a more robust coupling of the homogenous coating layer 202 to the first surface 106 as compared to the non-homogenous coating layer 104 when coupled to the first surface 106. In other words, the smaller non-columnar grains 208a, 208c of the homogenous coating layer 202 at the first surface 106 have a greater adhesion with the first surface 106 relative to the larger columnar grains 116a, 116b of the non-homogenous coating layer 104 such that there is a lower likelihood of peeling when utilizing the homogenous coating layer 202 instead of the non-homogenous coating layer 104.

In view of the above discussion, utilizing the homogenous coating layer 202 including the first, second, and third non-columnar grains 208a, 208b, 208c and the plurality of non-columnar grain boundaries 210 that are all relatively and substantially the same size (see Figure 2A and 2B of the present disclosure) reduces or prevents a likelihood of defects (*e.g*., cracks, peeling, etc.) from occurring as compared to utilizing the non-homogenous coating layer 104 with the columnar structure (see Figure 1A and 1B of the present disclosure) as discussed above. The homogenous coating layer 202 is more robust than the non-homogenous coating layer 104 as the homogenous coating layer 202 is more robust when exposed to changes in temperature (*i.e.*, increases or decreases in temperature) that causes expansion or contraction of the first, second, and third non-columnar grains 208a, 208b, 208c.

In view of the above discussion, the homogenous coating layer 202 will have a longer usable lifespan than the non-homogenous coating layer 104. In other words, the base portion 102 coated with the homogenous coating layer 202 will be capable of being utilized for processing a greater number of workpieces than when the base portion 102 is coated with the non-homogenous coating layer 104. In other words, the homogenous coating layer 202 is capable of undergoing many more thermal cycles before any defects propagate within the homogenous coating layer 202 as compared to the non-homogenous coating layer 104.

Figure 4 is a perspective view of an alternative embodiment of a heating chamber 500 of the present disclosure. The heating chamber 500 includes a container 502 and a lid 504. The container includes an opening 506 that provides access to a cavity 508 of the container 502 when the lid 504 is in an opened position as shown in Figure 4. The container 502 includes coated surfaces 510 that delimit the cavity 508 within the container 502. These coated surfaces 510 are present anywhere that would be exposed to a gas from a gas source when processing a plurality of workpieces 512 present within the cavity 508, and these coated surfaces 510 are coated with the homogenous coating layer 202. The plurality of workpieces 512 are present on transfer or support plates 514, which may be referred to as transfer or support disks, that have respective surfaces that would be exposed to the gas from the gas source coated with the homogenous coating layer 202. The plurality of workpieces 512 are inserted by placing the plurality of workpieces on several of the support plates 514 and then placing the support plates 514, on which the plurality of workpieces are present, into reception regions in the cavity 508 structured to receive the support plates 514. In other words, each reception region is structured to receive one of the support plates 514 as shown in Figure 4.

A gas inlet 516 is present at a center of the cavity 508 and is in fluidic communication with the gas source to provide the gas into the cavity 508 when the lid 504 is in a closed position when processing the plurality of workpieces 512 present within the cavity 508. A gas outlet or outlet recess 518 is present at a peripheral region of the cavity 508 of the container 502. When the lid 504 is in the closed position sealing the cavity 508, the gas from the gas source is introduced into the cavity 502 through the gas inlet 516. The gas is a SiH₄ gas, Si₂H₆ gas, GeH₄ gas, or some other similar or like type of gas. As the gas enters the cavity 508 through the gas inlet 516, the gas moves in a direction directed away from the gas inlet 516 towards the gas outlet 518 as represented by arrows 520. As the gas moves in the direction as represented by the arrows 520, the gas moves along the coated surfaces 510 within the container 502, the coated surfaces of the support plates 514, and exposed surfaces 522 of the plurality of workpieces 512 to form one or more epitaxial layers on the exposed surfaces 522 of the plurality of workpieces 512. As the respective coated surfaces 510 and the support plates 514 are coated with the homogenous coating layer 202, any propagation of defects is prevented or reduced in likelihood of occurring in the same manner as discussed earlier herein with respect to Figures 3A and 3B of the present disclosure, and, therefore, this discussion is not reproduced fully herein. These respective surfaces being coated with the homogenous coating layer 202 prevents or reduces the likelihood of contaminants (*e.g*., carbon) from being released into the cavity 508 when processing the plurality of workpieces 512 in the same manner as discussed earlier herein with respect to Figures 3A and 3B of the present disclosure, and, therefore, this discussion is not reproduced fully herein. In other words, the coated surfaces 510 and the coated support plates 514, which again are coated with the homogenous coating layer 202, prevent contaminants from being introduced into the cavity 508 during processing of the plurality of workpieces 512 as there is a low likelihood of defects propagating within the homogenous coating layer 202.

The lid 504 further includes an internal surface 523 that delimits the cavity 508 of the container 502 when the lid 504 is in the closed position. The internal surface 523 is coated with homogenous coating layer 202 as the internal surface 523 is to be exposed to the gas being introduced into the cavity 508 through the gas inlet 516 when processing the plurality of workpieces 512 by forming one or more epitaxial layers on the exposed surfaces 522 of the plurality of workpieces 512.

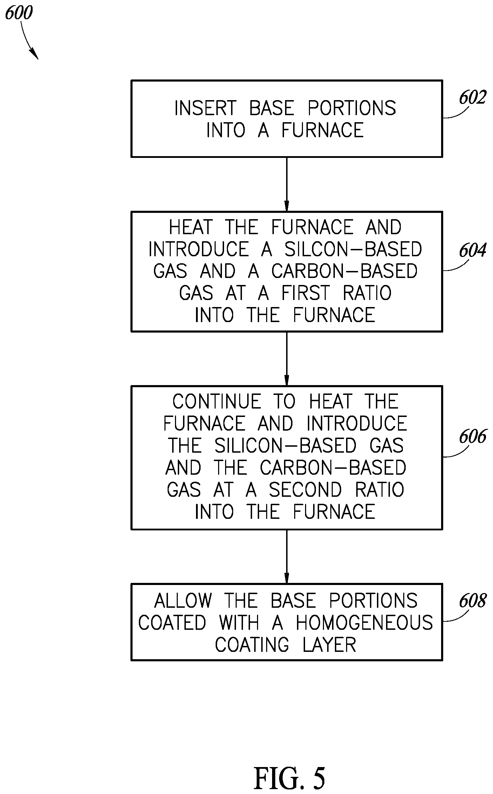

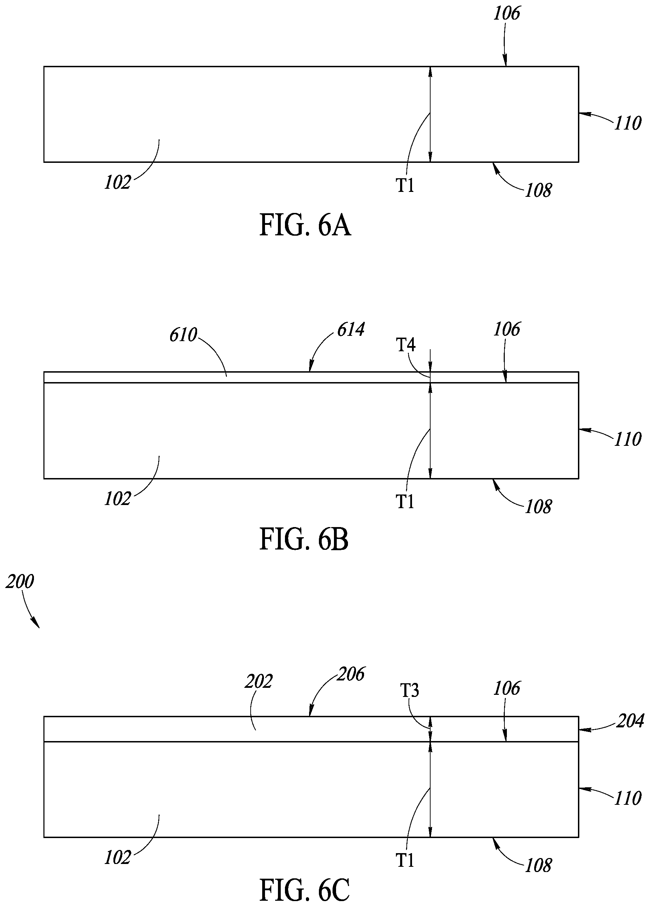

Figure 5 is a flowchart 600 of a method of manufacturing the structure 200 as shown in Figures 2A and 2B of the present disclosure in which the base portion 102 is coated with the homogenous coating layer 202. The flowchart 600 includes a first step 602, a second step 604, a third step 606, and a fourth step 608. Figures 6A-6C are side views of these respective steps 602, 604, 606, 608 of the flowchart 600 as shown in Figure 5 in the embodiment of the method of manufacturing the structure 200 with the homogenous coating layer 202 as shown in Figures 2A and 2B of the present disclosure.

In the first step 602, the base portion 102 (see Figure 6A), which has not yet been coated with the homogenous coating layer 202, is inserted into a cavity of a furnace (not shown). The furnace is configured to, in operation, heat the cavity of the furnace when forming the homogenous coating layer 202 on the first surface 106 of the base portion 102.

After the first step 602, in the second step 604 (see Figure 6B) a heating element of the furnace is turned on to heat the cavity in which the base portion 102 is present and gases from gas sources are introduced into the cavity of the furnace. A first gas of the gases is a silicon-based gas and a second gas of the gases is a carbon-based gas. The silicon-based gas and the carbon-based gas chemically react with each other such that the non-columnar grains 208a, 208b, 208c begin to form on the first surface 106 of the base portion 102. The cavity of the furnace is heated to a temperature up to 1700 degrees Celsius (°C) when forming the homogenous coating layer 202 on the first surface 106 of the base portion 102. The silicon-based gas (*e.g.*, SiH₄) and the carbon-base gas (*e.g.*, C₂H₄) are introduced to generate a first ratio of silicon and carbon of one-to-one (*i.e.*, 1:1 or one silicon for every one carbon) for a first period of time. This first period of time ranges from 5 minutes (min) to 120 minutes (min), or isequal to the upper and lower ends of this range. In some embodiments, this first period of time is equal to 60 minutes (mins) or 1 hour (hr). The results of this partial growing the non-columnar grains 208a, 208b, 208c of the homogenous coating layer 202 on the first surface 106 of the base portion is readily seen in Figure 6B.

For example, to generate this one-to-one ratio of silicon and carbon, the first ratio (*i.e.*, 1:1) is generated by introducing SiH₄ at a flowrate of 20 ml/min (*i.e.*, milliliters per min) and introducing C₂H₄ at a flowrate 10 ml/min (*i.e.*, milliliters per min) to generate this one-to-one ratio of silicon and carbon (*i.e*., one silicon to every one carbon).

In Figure 6B, a partially formed homogenous coating layer 610 is formed on the first surface 106 of the base portion 102. The partially formed homogenous coating layer 610 has a fourth thickness T4 that extends from the first surface 106 to a fourth surface 614 of the partially formed homogenous coating layer 610 that faces away from the base portion 102. The fourth thickness is less than the third thickness T3.

After the second step 604, in the third step 606 (see Figure 6C) the heating element continues to heat the cavity of the furnace and the silicon-based gas (*e.g.*, SiH₄) and the carbon-based gas (*e.g.*, C₂H₄) are introduced to generate a second ratio of silicon and carbon different from the first ratio (*i.e*., 1:1) of silicon and carbon. The heating element heats the cavity of the furnace to a temperature equal to 1575 degrees Celsius (°C). The second ratio is one-to-two (*i.e.*, 1:2) such that there is twice as much carbon relative to the silicon. For example, to generate this one-to-two (e.g., 1:2) ratio of silicon and carbon, the second ratio is generated by introducing SiH₄ at a flowrate of 20 ml/min (*i.e.*, milliliters per min) and introducing C₂H₄ at a flowrate 20 ml/min (*i.e.*, milliliters per min) to generate this one-to-two ratio of silicon and carbon (*i.e.*, one silicon to every two carbon). This change in parameters of the ratio of the silicon and the carbon results in growing different facets of the non-columnar grains 208a, 208b, 208c relative to the second step 604.

In this third step 606, the silicon-based gas (*e.g*., SiH₄) and the carbon-based gas (*e.g.*, C₂H₄) are introduced to generate the second ratio of silicon and carbon of one-to-two (*i.e*., 1:2 or one silicon for every two carbon) for a second period of time. This second period of time ranges from 5 minutes (min) to 120 minutes (min), or is equal to the upper and lower ends of this range. In some embodiments, this second period of time is equal to 60 minutes (mins) or 1 hour (hr).

In other words, in the second step 604 and the third step 606, the ratio of the silicon and carbon is essentially adjusted during a CVD process such that silicon-carbide is deposited directly onto and formed on the first surface 106 of the base portion 102. For example, during this formation or deposition of silicon-carbide directly onto the first surface 106 of the base portion 102 means that no material is present on the first surface 106 of the base portion 102 such that the homogenous coating layer 202 is formed directly onto the first surface 106 of the base portion 102. Furthermore, as silicon-carbide is formed and directly deposited onto the first surface 106 of the base portion 102 to form the homogenous coating layer 202 by changing the ratios of silicon and carbon, and, therefore, does not require an annealing step as silicon-carbide in the formation of the homogenous coating layer 202 on the first surface 106 of the base portion 102. By changing the ratio of the silicon and carbon during the CVD process results in the formation of the homogenous coating layer 202 on the first surface 106 of the base portion 102 with the physical properties as set forth earlier herein. Furthermore, when forming the homogenous coating layer 202 on the first surface 106 of the base portion, the homogenous coating layer 202 is grown on the first surface of the base portion 102, which is in at least one embodiment a polycrystalline or unstructured material, like graphite or polycrystalline SiC or Si. The quality of the first surface 106 of the baes portion 102 is preferable rough such that the first surface 106 of the base portion 102 has a roughness (Ra) of 3 to 10 nanometers (nm). This relatively high roughness can be used but may require a thicker layer to cover the first surface 106 of the base portion 102. The first surface 106 generally cannot be a monocrystalline since utilization of a monocrystalline would result in larger island growth and some grains will be very large (factor of 10 or larger compared to as desired) and this will lead to additional strain increasing the likelihood of cracking of the homogenous coating layer 202 when forming the homogenous coating layer 202 on the first surface 106 of the base portion 102.

In some embodiments, one or more additional steps occur after the second step 604 and the third step 606 and before the fourth step 608. For example, in at least one additional step after the third step 606, another step of introducing the one-to-one (*i.e*., 1:1) ratio of silicon and carbon is introduced into the furnace. In this at least one additional step, the silicon-based gas (*e.g.*, SiH₄) and the carbon-based gas (*e.g.*, C₂H₄) are introduced to again generate the first ratio of silicon and carbon. This change in parameters of the ratio of the silicon and carbon from the second ratio back to the first ratio results in growing different facets of the non-columnar grains 208a, 208b, 208c relative to the third step 606. For example, these facets of the non-columnar grains 208a, 208b, 208c being grown by switching back to the first ratio is the same or similar to those facets grown during the second step 604. Based on this discussion, in some embodiments, further additional steps (*e.g.*, a fourth step introducing the second ratio of silicon and carbon, a fifth step of the first ratio of silicon and carbon, and so forth) of switching back and forth between the first and second ratios of silicon and carbon being introduced into the furnace is performed to further facilitate growth of various facets of the non-columnar grains 208a, 208b, 208c of the homogenous coating layer 202.

Performing these additional steps of switching back and forth between the first and second ratios of silicon and carbon being introduced into the furnace allows for the formation and growth of the homogenous coating layer 202. In other words, performing any number of these steps of introducing the first and second ratios of silicon and carbon to the furnace allows for the formation and growth of the non-columnar grains 208a, 208b, 208c with various sizes and facets as desired onto the first surface 106 of the base portion 102. Performing these one or more additional steps to further facilitate growth of various facets of the non-columnar grains 208a, 208b, 208c, a greater number of layers than the non-columnar grains 208a, 208b, 208c of the homogenous coating layer 202 relative to those as shown in Figure 2B is formed on the first surface 106 of the base portion 102. Each one of these one or more additional steps may be performed for different selected periods of time. These different selected periods of time may range from 5 minutes (min) to 120 minutes (min), or is equal to the upper and lower ends of this range. In some embodiments, these different selected periods of time are equal to 60 minutes (mins) or 1 hour (hr). Performing or carrying out these one or more additional steps to further facilitate growth of the various facets of the non-columnar grains 208a, 208b, 208c results in the third thickness T3 of the homogenous coating layer 202 being equal to 20 µm.

After the third step 606, in the fourth step 608 the heating element is turned off and the gases from the gas sources are stopped from being introduced into the cavity of the furnace. The base portion 102 and the homogenous coating layer 202, which is now fully formed on the first surface 106 (see Figure 6C), are allowed to cool to room-temperature. After the base portion 102 and the homogenous coating layer 202 are cooled to room temperature, the base portion 102 and the homogenous coating layer now formed on the first surface 106 are removed from the cavity of the furnace. The base portion 102 is then utilized to form either one of the embodiments of the heating chambers 400, 500 as shown in Figures 3A, 3B, and 5, respectively, of the present disclosure.

By utilizing the flowchart 600 of the method of manufacturing the structure 200, the homogenous coating layer 202 of silicon-carbide (SiC) is formed. Once formed, the homogenous coating layer 202 has a silicon to carbon ratio in a range of 0.5 to 2.5, or has a silicon to carbon ratio equal to the upper and lower ends of this range. In some embodiments, the silicon to carbon ratio is equal to 2 such that there is a one-to-two ratio between silicon and carbon in which there is one silicon for every two carbon.

In some embodiments of the flowchart 600 of the method of manufacturing the structure 200, prior to growing the silicon-carbide (SiC) on the first surface 106 of the base portion 102, the first surface 106 of the base portion is etched with H₂ mixed with C₂H₄. This etching of the first surface 106 of the base portion 102 is performed by mixing H₂ at a flowrate of 80 ml/min (milliliters per min) with C₂H₄ at a flowrate of 0.5 ml/min (milliliters per min). In some embodiments, this etching process is performed in advance of inserting the base portion 102 into the furnace in the first step 602. Etching the first surface 106 of the base portion 102 in this fashion further facilitates the formation or growing of the homogenous coating layer 202 on the first surface of the base portion 102.

While not shown in the present disclosure, in at least one alternative embodiment of the structure 200 as shown in Figures 2A and 2B, the homogenous coating layer 202 is formed on the one or more first sidewalls 110 of the base portion 102. While not shown in the present disclosure, in at least one alternative embodiment, the homogenous coating layer 202 is formed on the second surface 108 of the base portion 102. While not shown in present disclosure, in various alternative embodiments, the homogenous coating layer 202 is formed on either one of, a combination of, or all of the first surface 106, the one or more first sidewalls 110, and the second surface 108 of the base portion 102. The selection of which ones of the first surface 106, the one or more first sidewalls 110, and the second surface 108 that are coated with the homogenous coating layer 202 depends on which of the surfaces of the base portion 102 would have been exposed to a gas during processing of workpieces if not coated by the homogenous coating layer 202 to prevent contaminants from being released by the base portion 102 when processing the workpieces. This is referred to as "off-gassing." In other words, the presence of the homogenous coating layer 202, the base portion 102 does not "off-gas" any contaminants into the cavity 412 of the heating chamber 400 preventing a semiconductor wafer being exposed to the contaminants due to this "off-gassing."

While the present disclosure discusses forming the homogenous coating layer 202 on the substrate 102, which is utilized in putting together or forming the heating chamber 400, or on the support plates or disks 522, which are utilized in the heating chamber 500, it will be readily appreciated that the homogenous coating layer 202 is formed on other respective surfaces of other respective structures or components, which will generally be graphite-based, graphene-based, graphite, or graphene structures or components. These other respective structures or components can be utilized to form yet another alternative embodiment of a heating chamber, which has a size and shape different than the embodiments of the heating chambers 400, 500 (see Figures 3A, 3B, and 4 of the present disclosure) as discussed in detail earlier herein. In other words, these alternative embodiments of the heating chambers can be structured and configured to, in operation, receive different sized and shape components for processing or manufacturing than those components sized and shaped to be inserted into the embodiments of the heating chamber 400, 500 (see Figures 3A, 3B, and 4 of the present disclosure) as discussed in detail earlier herein. For example, the base portion 102 has an ovular shape, a square shape, a diamond shape, a plus-shape, trapezoidal shape, or some other type of shape, profile, or 3-dimensional prism that is to be utilized in forming alternative embodiments of heating chambers.

At least one embodiment of a device of the present disclosure are summarized as including: a substrate in a heating chamber of a heating element, the substrate including a first surface; a silicon-carbide layer on the first surface of the substrate, the silicon-carbide layer including: a plurality of grains having a grain size within a grain size range of 1 µm to 5 µm, or equal to the upper and lower ends of the grain size range; and carbon to silicon ratio in a range of 0.5 to 2.5, or equal to the upper and lower ends of the silicon-carbide range.

The silicon-carbide layer is configured to, in operation, withstand temperatures at least up to 1700 degrees Celsius.

Optionally, the silicon-carbide layer includes a third surface spaced apart from the first surface of the substrate, and the plurality of grains are substantially homogenous in the grain size between the first surface and the third surface.

For example, the silicon-carbide layer has a thickness that extends from the first surface to the third surface within a thickness range of 1 µm to 10 µm, or equal to the upper and lower ends of the thickness range.

For example, each grain of the plurality of grains has a non-columnar structure.

A first grain distribution of the plurality of grains at a third surface of the silicon-carbide layer spaced apart from the first surface of the substrate is substantially equal to a second grain distribution of the plurality of grains at the first surface of the substrate.

For example, a third grain distribution of the plurality of grains between the third surface of the silicon-carbide layer and the first surface of the substrate is substantially equal to the first grain distribution and the second grain distribution.

For example, respective grains of the plurality of grains are non-columnar grains.

For example, the substrate is at least one of the following of a graphite substrate and a graphene substrate.

At least one embodiment of a device of the present disclosure can be summarized as including: a substrate including a first surface and a second surface opposite to the first surface; a silicon-carbide layer directly coupled to the first surface of the substrate, the silicon-carbide layer including: a third surface directly coupled to the first surface; a fourth surface spaced apart from the first surface and facing away from the first surface; a thickness extending from the third surface to the fourth surface; and a homogenous distribution of grain sizes of a plurality of grains entirely along the thickness.

For example, the silicon-carbide layer further includes a carbon to silicon ratio in a range of 0.5 to 2.5, or equal to the upper and lower ends of the range. Said differently, the carbon to silicon ratio in the range of 0.5 and 2.5, inclusively.

The grain sizes of the plurality of grains are within a grain size range from 1 µm to 5 µm, or are equal to the upper and lower ends of the grain size range. Said differently, the grain size is in the range of 1 µm and 5 µm, inclusively.

For example, the silicon-carbide layer has a thickness that extends from the first surface to the third surface within a thickness range of 3 µm to 30 µm, or equal to the upper and lower ends of the thickness range. The thickness is in the range of 3 µm and 30 µm, inclusively.

The silicon-carbide layer is configured to, in operation, withstand temperatures at least up to 1700 degrees Celsius.

For example, respective grains of the plurality of grains are non-columnar grains.

At least one embodiment of a method of the present disclosure can be summarized as including: forming a silicon-carbide layer with a homogenous distribution of grain sizes on a surface of a graphite substrate including: exposing the surface of the graphite surface of the substrate to a first ratio of silicon and carbide for a first selected period of time; and exposing the surface of the graphite surface of the substrate to a second ratio of silicon and carbide for a second selected period of time.

For example, the first and second selected periods of time is equal to each other.

For example, the first and second selected periods of time is equal to 1-hour.

For example, the first ratio is a one-to-one ratio of silicon to carbon.

For example, the second ratio is a one-to-two ratio of silicon to carbon.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A device, comprising:
a heating chamber (400);
a substrate (102) of the heating chamber (400), the substrate including a first surface (106);
a silicon-carbide layer (104) on the first surface (106) of the substrate (102), the silicon-carbide layer including a third surface (114) spaced apart from the first surface of the substrate, the plurality of grains being homogenous in grain size between the first surface (106) and the third surface (114).

2. The device of claim 1, wherein the grain size is in a range of 1 µm to 5 µm, or equal to 1 µm or equal to 5 µm;
And wherein the plurality of grains have a carbon to silicon ratio in a range of 0.5 to 2.5, or equal to 0.5 or equal to 2.5.

3. The device of claim 1, wherein the silicon-carbide layer (104) is configured to, in operation, withstand temperatures at least up to 1700 degrees Celsius.

4. The device of anyone of the preceding claims, wherein the silicon-carbide layer (104) has a thickness that extends from the first surface (106) to the third surface (114) within a thickness range of 3 µm to 30 µm, or equal to the upper and lower ends of the thickness range.

5. The device of anyone of the preceding claims, wherein each grain of the plurality of grains (116a, 116b) has a non-columnar structure.

6. The device of anyone of the preceding claims, wherein a first grain distribution of the plurality of grains at a third surface (114) of the silicon-carbide layer spaced apart from the first surface (106) of the substrate (102) is substantially equal to a second grain distribution of the plurality of grains (116a, 116b) at the first surface of the substrate.

7. The device of claim 6, wherein a third grain distribution of the plurality of grains (116a, 116b) between the third surface (114) of the silicon-carbide layer and the first surface (106) of the substrate is substantially equal to the first grain distribution and the second grain distribution.

8. The device of claim 7, wherein respective grains of the plurality of grains (116a, 116b) are non-columnar grains.

9. The device of anyone of the preceding claims, wherein the substrate (102) is at least one of the following of a graphite substrate and a graphene substrate.

10. A method, comprising:
forming a silicon-carbide layer with a homogenous distribution of grain sizes on a surface of a graphite substrate including:
exposing (604) the surface of the graphite surface of the substrate to a first ratio of silicon and carbide for a first selected period of time; and
exposing (606) the surface of the graphite surface of the substrate to a second ratio of silicon and carbide for a second selected period of time.

11. The method of claim 10, wherein the first and second selected periods of time are equal to each other.

12. The method of claim 11, wherein the first and second selected periods of time are equal to 1-hour.

13. The method of claim 10 or 11, wherein the first ratio is a one-to-one ratio of silicon to carbon.

14. The method of claim 13, wherein the second ratio is a one-to-two ratio of silicon to carbon.
